(19) Europäisches Patentamt
European Patent Office
Office européen des brevets

(11) Veröffentlichungsnummer: **0 011 742**
**A1**

# (12) EUROPÄISCHE PATENTANMELDUNG

(21) Anmeldenummer: **79104364.9**

(22) Anmeldetag: **07.11.79**

(51) Int. Cl.$^3$: **C 23 C 13/02**
C 08 J 7/06
//C08J7/02

(30) Priorität: **04.12.78 DE 2852341**

(43) Veröffentlichungstag der Anmeldung:
**11.06.80 Patentblatt 80/12**

(84) Benannte Vertragsstaaten:
**BE FR GB IT NL**

(71) Anmelder: **Vereinigte Flugtechnische Werke-Fokker Gesellschaft mit beschänkter Haftung**
**Hünefeldstrasse 1-5**
**D-2800 Bremen(DE)**

(72) Erfinder: **Lajain, Henri, Dr.**
**Rotdornallee 100**
**D-2800 Bremen(DE)**

(72) Erfinder: **Kühn, Karl**
**Bockhorner Weg 125**
**D-2800 Bremen(DE)**

(74) Vertreter: **Bischof, Hans-Jochen**
**Hünefeldstrasse 1-5**
**D-2800 Bremen 1(DE)**

## (54) Verfahren zur Metallisierung von Kunststoffoberflächen.

(57) Die Erfindung betrifft ein Verfahren zum Metallisieren von Kunststoffoberflächen, das durch folgende zum Teil bekannte Verfahrensschritte gekennzeichnet ist:

a) Reinigung der Oberflächen mit einem diese nur etwa monomolekular angreifenden Lösungsmittel,

b) Anordnung der Teile, in einer Hochvakuum-Aufdampfanlage,

c) Nachreinigung der Oberflächen durch Ionenbeschuß) wobei die als Anode geschaltete Glimmelektrode aus dem gleichen Material besteht, wie die aufzudampfende Metallschicht,

d) Bedampfung der Oberflächen bis zu der gewünschten Schichtdicke.

Das Lösungsmittel richtet sich nach dem verwendeten Kunststoff, der metallisiert werden soll. Wenn die aufzudampfende Metallschicht aus einem Material bestehen muß) das nicht geeignet ist, als Glimmelektrode beim Ionenbeschuß zur Nachreinigung verwendet zu werden, ist die Glimmelekttrode aus einem Material zu wählen, das ein mindestens nahezu gleiches Kristallgitter wie das Material der aufzudampfenden Schicht besitzt.

Bei einem glasfaser- oder kohlenstoffaserverstärkten Kunststoff aus Epoxyharz kann ein fluorhaltiges Lösungsmittel und besonders Aluminium zur Metallisierung verwendet werden, wobei eine als Anode geschaltete Elektrode aus Reinaluminium durch Ionenbeschuß die Nachreinigung bewirkt.

EP 0 011 742 A1

0011742

7824-38

Bremen, d. 30. November 1978
Vv24 B/Mei/we

Vereinigte Flugtechnische Werke-Fokker
Gesellschaft mit beschränkter Haftung

---

# Verfahren zur Metallisierung von Kunststoffoberflächen

---

Die Erfindung betrifft ein Verfahren zum Metallisieren von Kunststoffoberflächen unter Verwendung des an sich bekannten Aufdampfverfahrens im Hochvakuum.

Es ist bekannt, auf den Oberflächen von Werkstücken dünne Schichten durch Verdampfung von Materie in Hochvakuumanlagen aufzubringen. Diese dünnen Schichten können aus den verschiedensten Gründen auf diese Oberflächen aufgebracht werden, sei es, daß sie die Oberflächeneigenschaften verändern sollen oder aber diese Oberflächen schützen sollen. Ein spezielles Problem dabei ist jedoch stets die Frage, wie haftfest diese zusätzlichen Schichten auf den sie tragenden Oberflächen sind.

Wesentlich ist dabei selbstverständlich, daß die Oberflächen von jeglicher Verunreinigung befreit sind. Aus diesem Grunde erfolgt auch

grundsätzlich eine Vorbehandlung vor dem Einbringen der zu beschichtenden Oberflächen in die Hochvakuumanlagen. Eine weitere Reinigung im Hochvakuum selbst erfolgt in vielen Fällen durch ein Ionenbombardement, wobei etwaige Restverunreinigungen durch beschleunigte Ionen, teils von den Oberflächen abgeschlagen werden, teils durch Erhitzung aufgrund des Ionenbombardements zur Verdampfung gebracht werden.

Obwohl diese Verfahrensschritte allgemein bekannt sind, ergeben sich doch immer wieder Problemstellungen dadurch, daß auf bestimmte Oberflächen einerseits bestimmte andere Materialien aufgebracht werden sollen, die sich dann allerdings nicht miteinander vertragen, was letztenendes immer zur Folge hat, daß so aufgebrachte dünne Schichten nicht genügend auf der Unterlage haften.

Ein besonderes Problem bilden in diesem Zusammenhang Kunststoffoberflächen, die beschichtet werden sollen, sei es als Schutz der Kunststoffoberfläche oder etwa um diese elektrisch leitfähig zu machen, weil die meisten Kunststoffe schlechte elektrische Leiter sind.

Aufgabe der Erfindung ist es daher, ein Verfahren anzugeben, um insbesondere Kunststoffoberflächen mit metallischen Schichten zu versehen.

Es hat sich gezeigt, daß diese Aufgabe durch ein Verfahren lösbar ist, das aus folgenden zum Teil für sich bekannten Schritten besteht:

1. Vorreinigung der Kunststoffoberfläche durch Behandlung mit einem die Oberfläche selbst nur etwa monomolekular angreifenden Lösungsmittel.
2. Anordnung der zu behandelnden Oberflächen in einer Hochvakuumanlage derart, daß bei dem an sich bekannten Aufdampfen die Oberflächen selbst mit einer gleichmäßigen Schicht des Aufdampfmaterials belegt werden.
3. Nachreinigung der Oberflächen im Hochvakuum durch Ionenbombardemer

wobei die Ionen selbst aus dem gleichen Material wie die spätere Schicht bestehen und wobei die die Ionen aussendende Glimmelektrode als Anode geschaltet ist.
4. Aufdampfen der verlangten Schichten in an sich bekannter Weise.

Die als Anode geschaltete Glimmelektrode, die für das Ionenbombardement verwendet wird, kann auch aus einem anderen Material als dem Schichtmaterial bestehen, wenn das Kristallgitter des Materials der Glimmelektrode mindestens nahezu dem Kristallgitter der aufzudampfenden Schicht gleicht.

Besonders zweckmäßig lassen sich auf diese Weise metallische Schichten auf die Oberflächen von faserverstärkten Kunststoffen aufbringen, insbesondere auf kohlefaser- oder glasfaserverstärkte Kunststoffe, wobei der Kunststoff selbst ein Epoxyharz sein kann. In diesem Falle hat sich die Vorreinigung durch Eintauchen der zu beschichtenden Oberflächen in fluorhaltige Lösungsmittel als besonders vorteilhaft erwiesen. Zur Beschichtung derartiger Oberflächen mit einer haftfesten Metallschicht ist besonders Aluminium geeignet. Das Aluminium selbst sollte dabei eine Reinheit von mindestens 99,9 % aufweisen. Die so erzeugten Aluminiumschichten auf glas- oder kohlefaserverstärkten Kunststoffen sind besonders haftfest und bieten einen hervorragenden Schutz gegen eine Reihe von aggressiven Stoffen, insbesondere auch gegen Uranhexafluorid, wie es beispielsweise zur Isotopentrennung nach dem Zentrifugenverfahren verwendet wird.

Nach dem gleichen Verfahren lassen sich selbstverständlich auch andere Metalle auf andere Kunststoffe aufbringen. Entscheidend wichtig ist nur, daß einmal die Vorreinigung mit Mitteln erfolgt, die die Oberfläche selbst nur monomolekular angreifen. Das nachfolgende Ionenbombardement führt dann ganz offensichtlich dazu, daß in der Oberfläche Kristallisationskeime verbleiben, an die während des Aufdampfvorgangs die Schichten anwachsen. Das führt zu einer Verankerung der aufgedampften Schichten in der darunterliegenden Oberfläche selbst, mit der Folge einer großen Haftfestigkeit derartiger Schichten.

e) Anionische Polyacrylamide und/oder Salze der Formel IV

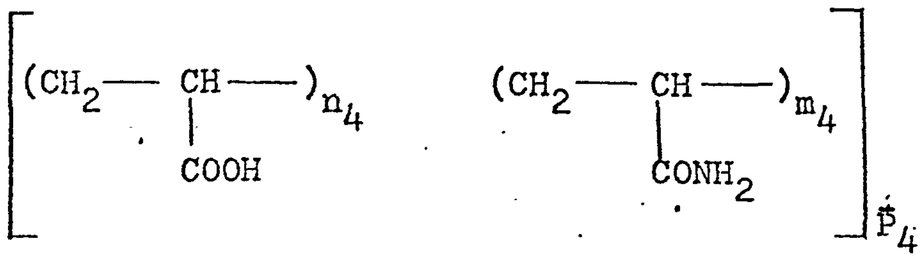

IV

worin bedeuten:

$n_4$ : 0,05 bis 0,95

$m_4$ : 0,95 bis 0,05

$n_4 + m_4 = 1$

$\bar{P}_4$ : 10 bis 500

wobei mindestens eines dieser Polymere in einer Menge von mindestens 10 Gew.% und mindestens 2 dieser Polymere in einer Menge von je mindestens 5 Gew.%, bezogen auf die Gesamtmenge der Polymeren, vorliegen.

Gegenstand der Erfindung ist weiterhin ein Verfahren zum Eindampfen von Zuckersäften enthaltend Zusatzstoffe zur Verhinderung der Ausbildung von Steinkrusten, das dadurch gekennzeichnet ist, daß man den Zuckersäften das vorstehend definierte Mittel zusetzt.

Wenn die Polymere als Salze vorliegen, sind Alkalimetallsalze, insbesondere Natriumsalze, bevorzugt. Grundsätzlich können auch andere Salze, z.B. Ammoniumsalze, Aminsalze oder Salze mit anderen Kation verwendet werden.

Die Mindestmenge hängt ab von der jeweiligen Wirksamkeit des gemäß der Erfindung verwendeten Gemisches und der Zusammensetzung des Zuckersaftes. In der Regel wird eine aus-

reichende Wirkung bereits erzielt, wenn die zugesetzte Menge entsprechend der vorstehenden Definition mindestens 1,0 ppm, vorzugsweise mindestens 2,5 ppm, beträgt. Eine ausreichende Wirkung, d.h. eine deutliche Reduzierung der Ausbildung von Steinkrusten in den Verdampfern während einer gesamten Zuckerkampagne derart, daß, abhängig von der Zuckersaftzusammensetzung nur am Ende der Kampagne oder vielleicht nur einmal während der Kampagne eine Reinigung der Anlage erforderlich ist, wird im allgemeinen schon dann erreicht, wenn dem Zuckerdünnsaft maximal 10 ppm, in vielen Fällen maximal 6 ppm und häufig so geringe Mengen wie nur maximal 4 ppm zugesetzt werden. Dies ist eine extrem niedrige Menge eines Zusatzstoffes zur Verhinderung der Ausbildung von Steinkrusten, wie sie bisher nicht für möglich gehalten wurde. Das Mittel gemäß der Erfindung wird dem einzudampfenden Zuckersaft in der Regel in mehreren Raten zugesetzt, d.h. vor und zwischen den einzelnen Verdampferstufen. Das Eindampfen von Zuckersäften erfolgt regelmäßig in Anlagen, die mehrere hintereinander geschaltete Verdampferstufen aufweise Nachdem der Zuckersaft einen oder mehrere Verdampfer passiert hat, wird er naturgemäß zunehmend konzentriert. Die vorstehend angegebenen Mengen stellen die insgesamt zugesetzten Mengen der Polymeren dar. Sie beziehen sich jedoch auf das Gewicht des Zuckerdünnsaftes vor Eintritt in die erste Verdampferstufe. Wenn z.B. 3 ppm des Mittels dem Zuckerdünnsaft, bezogen auf dessen Gewicht vor Eintritt in die erste Verdampferstufe, zugesetzt werden, kann z.B. die Hälfte dieser Menge vor Eintritt in die erste Verdampferstufe, ein Viertel vor dem Eintritt in die dritte Verdampferstufe und ein Viertel vor dem Eintritt in die fünfte Verdampferstufe zugesetzt werden. Die Auswahl der Dosierstellen hängt von der Heizflächenverteilung in Bezug auf die einzelnen Verdampferstufen ab. Die Erfindung ist gleichermaßen anwendbar auf Rohrzucker und Rübenzucker.

Bevorzugt sind solche Polymere der obigen Formel I, worin die Symbole die folgenden Bedeutungen haben:

7824-38

Bremen, d. 30. November 1978
Vv24 B/Mei/we

## A n s p r ü c h e

1. Verfahren zum Metallisieren von Kunststoffoberflächen, insbesondere von faserverstärkten Kunststoffen, g e k e n n z e i c h n e t durch folgende zum Teil für sich bereits bekannte Verfahrensschritte:
   a) Reinigung der zu metallisierenden Oberflächen mittels eines die Oberfläche selbst nur etwa monomolekular angreifenden Lösungsmittels, beispielsweise im Tauchverfahren,
   b) Anordnung der Bauteile, deren Oberflächen zu metallisieren sind in einer Hochvakuum-Aufdampfanlage derart, daß während des Bedampfungsvorgangs die zu behandelnden Oberflächen mit einer gleichmäßigen Schicht bedampfbar sind,
   c) Nach-reinigung der zu metallisierenden Oberflächen durch Ionenbeschuß in der Vakuumanlage, wobei die Glimmelektrode aus dem gleichen Material besteht, wie die aufzudampfende Metallschicht, und wobei die Glimmelektrode als Anode geschaltet ist und
   d) Bedampfung der zu metallisierenden Oberflächen bis zu der gewünschten Schichtdicke.

2. Verfahren nach Anspruch 1, dadurch g e k e n n z e i c h n e t, daß die Glimmelektrode aus einem Material besteht, das ein mindestens nahezu gleiches Kristallgitter wie das Material der aufzudampfenden Schicht besitzt.

3. Verfahren nach Anspruch 1 oder 2, dadurch g e k e n n z e i c h n e t, daß es sich bei dem faserverstärkten Kunststoff um glasfaser- oder kohlenstoffaserverstärkten Kunststoff handelt, wobei der Kunststoff selbst ein Epoxyharz ist.

4. Verfahren nach Anspruch 3, dadurch g e k e n n z e i c h n e t, daß die Vorreinigung der zu metallisierenden Kunststoffoberflächen durch Eintauchen in ein fluorhaltiges Lösungsmittel erfolgt.

5. Verfahren nach Anspruch 3 oder 4, dadurch g e k e n n z e i c h n e t, daß die Kunststoffoberfläche mit einer Aluminiumschicht bedampft wird.

6. Verfahren nach Anspruch 5, dadurch g e k e n n z e i c h n e t, daß die Nachreinigung im Hochvakuum durch Ionenbeschuß mittels einer Aluminiumelektrode aus Reinaluminium erfolgt, die als Anode geschaltet ist.

Europäisches Patentamt

# EUROPÄISCHER RECHERCHENBERICHT

0011742

Nummer der Anmeldung

EP 79 10 4364

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | IBM TECHNICAL DISCLOSURE BULLETIN, Band 9, Nr. 3, August 1966, J.G. BOLES "Metallizing flat cable" Seiten 245-246. | |
| A | DE - A - 2 000 848 (DEGUSSA) | |
| A | US - A - 3 783 012 (K. MORITA) | |
| A | FR - A - 1 547 700 (C.G.E.) | |

KLASSIFIKATION DER ANMELDUNG (Int.Cl. [3])

C 23 C 13/02
C 08 J 7/06//
C 08 J 7/02

RECHERCHIERTE SACHGEBIETE (Int. Cl. [3])

C 23 C 13/00
13/02
C 08 J 7/06
7/02

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 05-03-1980 | DEVISME |